# EUROPÄISCHE PATENTSCHRIFT

(11) **EP 3 535 847 B1**
(45) Veröffentlichungstag und Bekanntmachung des Hinweises auf die Patenterteilung: **05.07.2023**
(21) Anmeldenummer: 17787923.6
(22) Anmeldetag: 25.10.2017
(51) Int. Cl.: H03K 17/96

(54) **SCHEIBENANORDNUNG MIT EINER VERBUNDSCHEIBE MIT ERWEITERTEM KAPAZITIVEM SCHALTBEREICH**
COMPOUND GLAZING WITH EXPANDED CAPACITIVE SWITCHING RANGE
VITRE COMPOSITE COMPRENANT UNE ZONE DE COMMUTATION CAPACITIVE ÉLARGIE

(30) Priorität: 04.11.2016 EP 16197265
(43) Veröffentlichungstag der Anmeldung: 11.09.2019
(73) Patentinhaber: SAINT-GOBAIN GLASS FRANCE, 92400 Courbevoie (FR)
(72) Erfinder: WEBER, Patrick, 52477 Alsdorf (DE); DROSTE, Stefan, 52134 Herzogenrath (DE)
(74) Vertreter: Gebauer, Dieter Edmund
(86) Internationale Anmeldenummer: PCT/EP2017/077228
(87) Internationale Veröffentlichungsnummer: WO 2018/082977

(56) Entgegenhaltungen:
- US-A1- 2016 313 587
- US-B1- 6 654 070

## Beschreibung

Die Erfindung betrifft eine Scheibenanordnung mit einer Verbundscheibe mit erweitertem kapazitivem Schaltbereich, ein Verfahren zur Herstellung der Scheibenanordnung und deren Verwendung.

Es ist bekannt, dass kapazitive Schaltbereiche durch eine Sensorelektrode oder durch eine Anordnung von zwei gekoppelten Sensorelektrodenbereichen, wie einen ersten Teilbereich und einen Umgebungsbereich, ausgebildet werden können. Nähert sich ein Objekt der Sensorelektrode an, so ändert sich die Kapazität der Sensorelektrode gegen Erde oder die Kapazität des von den zwei gekoppelten Sensorelektrodenbereichen gebildeten Kondensators. Derartige Sensorelektroden sind beispielsweise aus US 2016/0313587 A1, US 6654070 B1, US 2010/179725 A1, WO 2015/086599 A1, WO 2016/116372 A1, US 6 654 070 B1 und US 2006/275599 A1 bekannt.

Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Sensoren sind beispielsweise aus DE 20 2006 006 192 U1, EP 0 899 882 A1, US 6,452,514 B1 und EP 1 515 211 A1 bekannt.

Die Aufgabe der vorliegenden Erfindung besteht darin, eine verbesserte Schaltanordnung mit einer Verbundscheibe bereitzustellen, die einen erweiterten kapazitiven Schaltbereich aufweist, der einfach und kostengünstig in die Verbundscheibe integriert werden kann. Mit dem erweiterten kapazitiven Schaltbereich kann in einfacher Weise ein Berührungs- oder Annäherungssensor gebildet werden.

Die Aufgabe der vorliegenden Erfindung wird erfindungsgemäß durch eine Scheibenanordnung mit einer Verbundscheibe mit erweitertem kapazitivem Schaltbereich gemäß dem unabhängigen Anspruch 1 gelöst. Bevorzugte Ausführungen gehen aus den Unteransprüchen hervor.

Die erfindungsgemäße Schaltanordnung mit Verbundscheibe mit erweitertem kapazitivem Schaltbereich umfasst zumindest die folgenden Merkmale:
- eine erste Scheibe und eine zweite Scheibe, die durch mindestens eine Zwischenschicht, bevorzugt eine thermoplastische Zwischenschicht, miteinander verbunden sind und bevorzugt flächig miteinander verbunden sind,
- ein elektro-optisches Funktionselement,
- eine Sensorelektrode, die zwischen der ersten Flächenelektrode und der ersten Scheibe angeordnet ist,
   wobei die Sensorelektrode kapazitiv mit der ersten Flächenelektrode gekoppelt ist,
- eine kapazitive Sensorelektronik, die mit der Sensorelektrode elektrisch verbunden ist, wobei die Empfindlichkeit der Sensorelektronik so gewählt ist, dass sie bei Berührung der außenseitigen Oberfläche der ersten Scheibe über der ersten Flächenelektrode oder der Annäherung an die außenseitige Oberfläche der ersten Scheibe über der ersten Flächenelektrode mit einem menschlichen Körperteil, wie einem Finger oder einer Hand, ein Schaltsignal ausgibt.

Die Berührung oder Annäherung muss dabei nicht über oder in der Nähe der Sensorelektrode stattfinden, sondern es genügt eine Berührung oder Annäherung der außenseitigen Oberfläche der ersten Scheibe über der gesamten ersten Flächenelektrode.

Das elektro-optische Funktionselement umfasst zumindest:
- eine erste Flächenelektrode,
- eine elektro-optische Funktionsschicht und
- eine zweite Flächenelektrode,
wobei das elektro-optische Funktionselement zumindest abschnittsweise zwischen der ersten Scheibe und der zweiten Scheibe angeordnet ist.

Das elektro-optische Funktionselement ist ein flächenhaftes Funktionselement mit elektrisch regelbaren optischen Eigenschaften. Das heißt, seine optischen Eigenschaften und insbesondere seine Transparenz, sein Streuverhalten oder seine Leuchtkraft sind durch ein elektrisches Spannungssignal steuerbar. Elektro-optische Funktionselemente, deren Transparenz sich durch ein elektrisches Spannungssignal steuern lassen, enthalten als elektro-optische Funktionsschicht bevorzugt eine oder mehrere SPD-Folien (SPD ₌ Suspended particle device), Flüssigkristall-haltige Folien, wie PDLC-Folien (PDLC ₌ Polymer dispersed liquid crystal) oder elektrochrome Schichtsysteme. Elektro-optische Funktionselemente, deren Leuchtkraft sich durch ein elektrisches Spannungssignal steuern lassen, enthalten als elektro-optische Funktionsschicht bevorzugt eine oder mehrere OLED-Schichtsystems (OLED, englisch organic light emitting diode; organische Leuchtdiode) oder Display-Folien, besonders bevorzugt OLED-Display-Folien und ganz besonders bevorzugt transparente OLED-Display-Folien.

In einer vorteilhaften Ausgestaltung der Erfindung ist die Zwischenschicht eine thermoplastische Zwischenschicht. In einer weiteren vorteilhaften Ausgestaltung der Erfindung sind mindestens zwei, bevorzugt genau zwei, Zwischenschichten zwischen der ersten Scheibe und der zweiten Scheibe angeordnet. Dabei ist zwischen der ersten Scheibe und dem elektro-optischen Funktionselement eine erste Zwischenschicht angeordnet und zwischen dem elektro-optischen Funktionselement und der zweiten Scheibe ist eine zweite Zwischenschicht angeordnet.

Das elektro-optische Funktionselement ist zumindest abschnittsweise zwischen der ersten Scheibe und der zweiten Scheibe angeordnet. Abschnittsweise bedeutet hier, dass das elektro-optische Funktionselement nicht die volle Fläche der ersten Scheibe oder der zweiten Scheibe bedecken muss, sondern beispielsweise nur einen Teilbereich, wie ein schmalen bandförmigen Streifen.

Bei der Verbundscheibe ist das elektro-optische Funktionselement derart orientiert, dass dessen erste Flächenelektrode der ersten Scheibe zugewandt ist und dessen zweite Flächenelektrode der zweiten Scheibe zugewandt ist.

Die Sensorelektrode ist bevorzugt abschnittsweise zwischen der ersten Flächenelektrode und der ersten Scheibe angeordnet. Abschnittsweise bedeutet hier, dass die Sensorelektrode nicht die volle Fläche der ersten Scheibe oder der zweiten Scheibe bedeckt, sondern nur einen Teilbereich, wie eine kreisförmige Fläche, einen schmalen bandförmigen Streifen, einen linienförmigen Draht oder ähnliches.

Zwischen der ersten Flächenelektrode und der ersten Scheibe angeordnet bedeutet hier, dass die Sensorelektrode im Bereich der orthogonalen Projektion der ersten Flächenelektrode zwischen der ersten Flächenelektrode und der ersten Scheibe angeordnet ist.

Die Sensorelektrode ist kapazitiv mit der ersten Flächenelektrode gekoppelt. Das heißt die Sensorelektrode ist zumindest im Bereich der Verbundscheibe und vor einer Sensorelektronik beziehungsweise einer Steuerungselektronik für das elektro-optische Funktionselement galvanisch von der ersten Flächenelektrode isoliert.

Bei einer Verbundscheibe nach dem Stand der Technik, bei dem die Sensorelektrode nicht mit der ersten Flächenelektrode kapazitiv gekoppelt ist oder bei der beispielsweise keine weiteren elektrisch leitfähigen Bereiche in der Verbundscheibe integriert sind, ist der räumliche Bereich, der sich durch orthogonale Projektion der Sensorelektrode auf die außenseitige Oberfläche IV der ersten Scheibe ergibt, nur so groß wie die Sensorelektrode selbst. Der Bereich wird im Folgenden der kapazitive Schaltbereich genannt. Bei einer Berührung oder Annäherung mit einem menschlichen Körperteil an den kapazitiven Schaltbereich kann über eine Sensorelektronik, die mit der Sensorelektrode elektrisch leitend verbunden ist, ein Schaltsignal gemessen werden.

Wie Untersuchungen der Erfinder überraschenderweise ergeben haben, kann durch die erfindungsgemäße kapazitive Kopplung der Sensorelektrode mit der ersten Flächenelektrode der kapazitive Schaltbereich erweitert werden. Der erweiterte kapazitive Schaltbereich, das heißt der effektiv wirksame Bereich, in dem durch eine Berührung der außenseitigen Oberfläche IV der ersten Scheibe oder durch eine Annäherung daran ein kapazitives Schaltsignal messbar ist, ist auf die Fläche der orthogonalen Projektion der ersten Flächenelektrode auf die außenseitige Oberfläche IV ausgedehnt. Dies erhöht den Bedienkomfort und macht ein Schalten durch Berührung oder Annäherung über einen großen Bereich der Verbundscheibenfläche möglich. Des Weiteren entfällt die Notwendigkeit, den Bereich der kapazitiven Schaltfläche einer transparenten Sensorelektrode zu markieren oder hervorzuheben.

Erfindungsgemäße Sensorelektroden können einteilig oder mehrteilig ausgebildet sein und beispielsweise aus einem ersten Teilbereich der Sensorelektrode und einem zweiten Teilbereich bestehen. Der zweite Teilbereich wird im Folgenden auch Umgebungsbereich oder Massebereich genannt.

In einer vorteilhaften Ausgestaltung der Erfindung wird die Sensorelektrode aus einer gedruckten und eingebrannten elektrisch leitfähigen Paste, bevorzugt eine silberhaltige Siebdruckpaste gebildet. Die gedruckte und eingebrannte elektrisch leitfähige Paste hat vorteilhafterweise eine Dicke von 3 µm bis 20 µm und einen Flächenwiderstand von 0,001 Ohm/Quadrat bis 0,03 Ohm/Quadrat, bevorzugt von 0,002 Ohm/Quadrat bis 0,018 Ohm/Quadrat. Derartige Sensorelektroden sind im industriellen Fertigungsprozess leicht zu integrieren und kostengünstig herzustellen.

In einer weiteren vorteilhaften Ausgestaltung der Erfindung besteht die Sensorelektrode aus einer elektrisch leitfähigen Folie, bevorzugt einer Metallfolie und insbesondere einer Kupfer-, Silber-, Gold- oder Aluminiumfolie. Die elektrisch leitfähige Folie weist vorteilhafterweise eine Dicke von 50 µm bis 1000 µm und bevorzugt von 100 µm bis 600 µm auf. Die elektrisch leitfähige Folie hat vorteilhafterweise eine Leitfähigkeit von 1*10⁶ S/m bis 10*10⁷ S/m und bevorzugt von 3,5*10⁷ S/m bis 6,5*10⁷ S/m.

Es versteht sich, dass derartige Folien auch auf Trägerfolien, beispielsweise polymeren Trägerfolien wie Polyimid oder Polyethylenterephthalat (PET), angeordnet sein können. Derartige Sensorelektroden auf Trägerfolien sind besonders vorteilhaft, da auch mehrteilige Sensorelektroden aus beispielsweise einem ersten Teilbereich der Sensorelektrode und einem Umgebungsbereich (Massebereich) aus einer Einheit hergestellt werden können und während der Fertigung bequem und positionsgenau in die spätere Fahrzeugantennenscheibe eingelegt werden können.

In einer weiteren vorteilhaften Ausgestaltung der Erfindung besteht die Sensorelektrode aus mindestens einem elektrisch leitfähigen Draht, bevorzugt einem Metalldraht und insbesondere einem Wolfram-, Kupfer-, Silber-, Gold- oder Aluminiumdraht. Es versteht sich, dass derartige Drähte auch auf den beispielsweise oben genannten Trägerfolien angeordnet sein können. Der elektrisch leitfähige Draht ist bevorzugt mit einer elektrischen Isolation umgeben, beispielsweise mit einem Kunststoffmantel. Besonders geeignete Drähte haben eine Dicke von 10 µm bis 200 µm, bevorzugt von 20 µm bis 100 µm und besonders bevorzugt von 30 µm oder 70 µm.

In einer weiteren vorteilhaften Ausgestaltung der Erfindung besteht die Sensorelektrode aus einer elektrisch leitfähigen Struktur, die aus einer elektrisch leitfähigen Schicht durch einen beschichtungsfreien Trennbereich, insbesondere eine beschichtungsfreie Trennlinie, von der umgebenden Schicht elektrisch isoliert ist. In einer vorteilhaften Ausgestaltung beträgt die Breite der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

Die elektrisch leitfähige Schicht ist bevorzugt transparent. Die elektrisch leitfähige Schicht kann unmittelbar auf die innenseitige Oberfläche III der ersten Scheibe auf der ersten Zwischenschicht oder auf einer zusätzlichen Trägerfolie, bevorzugt einer transparente Trägerfolie angeordnet werden. Bevorzugt sind beispielsweise polymere Trägerfolie aus beispielsweise Polyimid oder Polyethylenterephthalat (PET).

Erfindungsgemäße elektrisch leitfähige Schichten sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und oder Chrom, oder eine Metalllegierung. Die funktionellen Schichten enthalten besonders bevorzugt mindestens 90 Gew. % des Metalls, insbesondere mindestens 99,9 Gew. % des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Dielektrische Schichten können aber auch mehrere Einzelschichten umfassen, beispielsweise Einzelschichten eines dielektrischen Materials, Glättungsschichten, Anpassungsschichten, Blockerschichten und / oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie Vakuumverdampfung oder PVD(physical vapour deposition) -Verfahren wie die magnetfeldgestützte Kathodenzerstäubung oder CVD(chemical vapour deposition)-Verfahren durchgeführt werden.

Weitere geeignete elektrisch leitfähige Schichten enthalten bevorzugt Indium-Zinnoxid (ITO), fluordotiertes Zinnoxid (SnO₂:F) oder aluminiumdotiertes Zinkoxid (ZnO:Al) oder bestehen daraus.

Die elektrisch leitfähige Schicht kann prinzipiell jede Beschichtung sein, die elektrisch kontaktiert werden kann. Soll die erfindungsgemäße Verbundscheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die elektrisch leitfähige Schicht eine Schicht oder ein Schichtaufbau mehrerer Einzelschichten mit einer Gesamtdicke von kleiner oder gleich 2 µm, besonders bevorzugt kleiner oder gleich 1 µm.

Eine vorteilhafte erfindungsgemäße transparente elektrisch leitfähige Schicht weist einen Flächenwiderstand von 0,4 Ohm/Quadrat bis 200 Ohm/Quadrat auf. In einer besonders bevorzugten Ausgestaltung weist die erfindungsgemäße elektrisch leitfähige Schicht einen Flächenwiderstand von 0,5 Ohm/Quadrat bis 20 Ohm/Quadrat auf.

Die elektrisch leitfähige Schicht enthält bevorzugt eine transparente, elektrisch leitfähige Beschichtung. Transparent bedeutet hier durchlässig für elektromagnetische Strahlung einer Wellenlänge von 300 nm bis 1.300 nm und insbesondere für sichtbares Licht.

In einer vorteilhaften Ausgestaltung der erfindungsgemäßen Scheibe beträgt die Breite t₁ der Trennlinien, mit denen die elektrisch leitfähige Schicht elektrisch unterteilt ist, von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

Falls es nicht erforderlich ist, dass die elektrisch leitfähige Schicht transparent ausgestaltet ist, weil die Sensorelektrode beispielsweise in einem Bereich der Verbundscheibe angeordnet ist, in dem die Durchsicht durch einen Abdeckdruck oder eine Kunststoffgehäuse verhindert ist, kann die elektrisch leitfähige Schicht auch deutlich dicker als bei transparenten elektrisch leitfähigen Schichten ausgestaltet sein. Derartige dickere Schichten können einen deutlich niedrigeren Flächenwiderstand aufweisen.

Es versteht sich, dass Sensorelektroden aus den genannten Ausgestaltungformen, wie gedruckte Paste, elektrisch leitfähige Folie oder Drähte und abgetrennte elektrisch leitfähige Schicht, miteinander kombiniert werden können. Das heißt, dass der erste Teilbereich beispielsweise aus einer elektrisch leitfähigen Folie bestehen kann und der Umgebungsbereich aus einer gedruckten Paste, usw.

In einer vorteilhaften Ausgestaltung der erfindungsgemäßen Sensorelektrode hat die Sensorelektrode oder zumindest der erste Teilbereich der Sensorelektrode eine Fläche von 1 cm² bis 200 cm², besonders bevorzugt von 1 cm² bis 9 cm². Die Länge des Berührungsbereichs beträgt bevorzugt von 1 cm bis 14 cm und besonders bevorzugt von 1 cm bis 3 cm. Die maximale Breite des Berührungsbereichs beträgt bevorzugt von 1 cm bis 14 cm und besonders bevorzugt von 1 cm bis 3 cm. Die Sensorelektrode oder zumindest der erste Teilbereich der Sensorelektrode kann prinzipiell jede beliebige Form aufweisen. Besonders geeignete sind kreisförmige, elliptische oder tropfenförmige Ausgestaltungen. Alternativ sind eckige Formen möglich, beispielsweise Dreiecke, Quadrate, Rechtecke, Trapeze oder anders geartete Vierecke oder Polygone höherer Ordnung. Allgemein ist es besonders vorteilhaft, wenn etwaige Ecken abgerundet sind. Die Sensorelektrode kann auch ein linienförmiges Element, beispielsweise einen Draht enthalten, das spiral-, kamm- oder rasterförmig ausgestaltet ist und dessen äußere Ausdehnung die kapazitive Kopplungsfläche der Sensorelektrode vergrößert.

In einer vorteilhaften Ausgestaltung ist die Sensorelektrode einteilig ausgebildet. Die Sensorelektrode ist mit der ersten Flächenelektrode kapazitiv gekoppelt, so dass sich ein erweiterter kapazitiver Schaltbereich auf der außenseitigen Oberfläche IV der ersten Scheibe ergibt. Die einteilige Sensorelektrode kann mit einer beispielsweise externen (das heißt außerhalb der Verbundscheibe) kapazitiven Sensorelektronik verbunden werden. Über die kapazitive Sensorelektronik wird die Kapazität der Sensorelektrode und der daran gekoppelten ersten Flächenelektrode gemessen. Die Kapazität der Sensorelektrode und der daran gekoppelten ersten Flächenelektrode ändert sich gegen Erde, wenn ein Körper (beispielsweise ein menschlicher Körper), in ihre Nähe kommt oder beispielsweise eine Isolatorschicht über der Sensorelektrode und der daran gekoppelten ersten Flächenelektrode berührt. Die Isolatorschicht umfasst insbesondere das Material der erste Scheibe selbst. Die Kapazitätsänderung wird durch die Sensorelektronik gemessen und bei Überschreiten eines Schwellwerts wird ein Schaltsignal ausgelöst. Der erweiterte kapazitive Schaltbereich wird durch Form und Größe der ersten Flächenelektrode festgelegt.

In einer alternativen vorteilhaften Ausgestaltung ist die Sensorelektrode mehrteilig und bevorzugt zweitteilig ausgebildet. Das heißt die Sensorelektrode weist einen ersten Teilbereich und einen Umgebungsbereich auf. Sowohl der erste Teilbereich als auch der Umgebungsbereich können mit einer kapazitive Sensorelektronik verbunden werden.

In einer solchen Anordnung bilden der erste Teilbereich und der Umgebungsbereich zwei Elektroden aus, die kapazitiv mit der ersten Flächenelektrode und miteinander gekoppelt sind. Die Kapazität des von den Elektroden gebildeten Kondensators ändert sich bei Annäherung eines Körpers, beispielsweise eines menschlichen Körperteils. Die Kapazitätsänderung wird durch eine Sensorelektronik gemessen und bei Überschreiten eines Schwellwerts wird ein Schaltsignal ausgelöst. Der erweiterte kapazitive Schaltbereich, also der sensitive Bereich, wird durch Form und Größe des Bereichs der ersten Flächenelektrode, der mit dem System aus erstem Teilbereich und Umgebungsbereich kapazitiv gekoppelt ist, festgelegt.

Der erweiterte kapazitive Schaltbereich ist in die Verbundscheibe integriert. Es ist also kein Schalter oder ähnliches als separates Bauteil nötig, welches an der Verbundscheibe angebracht werden muss. Die Verbundscheibe weist bevorzugt auch keine sonstigen Bauteile auf, die im Durchsichtbereich auf ihren Oberflächen angeordnet sind. Das ist besonders vorteilhaft im Hinblick auf eine dünne Bauweise der Verbundscheibe sowie einer nur geringen Störung der Durchsicht durch die Verbundscheibe.

Die Erfindung umfasst eine Scheibenanordnung mit einer Verbundscheibe und einer Sensorelektronik, die über einen Anschlussbereich mit der Sensorelektrode elektrisch verbunden ist. Die Sensorelektronik ist eine kapazitive Sensorelektronik.

In einer vorteilhaften Ausgestaltung der erfindungsgemäßen Schaltanordnung ist die Empfindlichkeit der Sensorelektronik so gewählt, dass die Sensorelektronik bei Berührung des Berührungsbereichs mit einem menschlichen Finger auf der außenseitigen Oberfläche IV der ersten Scheibe im erweiterten kapazitiven Schaltbereich (also in Bereich der orthogonalen Projektion der ersten Flächenelektrode auf die außenseitige Oberfläche IV der ersten Scheibe) ein Schaltsignal ausgibt und bei Berührung des Berührungsbereichs auf der außenseitigen Oberfläche I der zweiten Scheibe kein Schaltsignal oder ein anderes Schaltsignal ausgibt. Die Asymmetrie des Schaltverhaltens wird durch die zweite Flächenelektrode verstärkt, die die Kapazitätsänderung der ersten Flächenelektrode zumindest anteilig abschirmen kann. Es versteht sich, dass die Berührung des Berührungsbereichs auch mit mehreren Fingern oder einem anderen menschlichen Körperteil erfolgen kann. Unter Berührung wird im Rahmen dieser Erfindung jegliche Wechselwirkung mit dem Schaltbereich verstanden, die zu einer messbaren Änderung des Messsignals, also hier der Kapazität, führt. Die Empfindlichkeit der Sensorelektronik kann auch so gewählt werden, dass eine Annäherung an die außenseitige Oberfläche IV der ersten Scheibe im erweiterten kapazitiven Schaltbereich bereits genügt um ein Schaltereignis auszulösen und eine direkte Berührung nicht notwendig ist.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6V bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Die Empfindlichkeit der Sensorelektronik kann in Abhängigkeit der Größe des erweiterten kapazitiven Schaltbereichs und in Abhängigkeit der Dicke von erster Scheibe, Zwischenschicht(en) und gegebenenfalls zweiter Scheibe im Rahmen einfacher Experimente ermittelt werden.

Der besondere Vorteil einer solchen erfindungsgemäßen Scheibenanordnung liegt darin, dass das Schaltsignal nur bei Berührung der Verbundscheibe von einer der außenseitigen Oberflächen ausgelöst werden kann. Bei einer Verwendung der Scheibenanordnung in einer Fahrzeugscheibe und Einbau der Verbundscheibe mit der ersten Scheibe in Richtung des Fahrzeuginnenraums, kann beispielsweise ein Auslösen des Schaltvorgangs durch Personen von außen oder ein ungewolltes Auslösen des Schaltvorgangs durch Regen oder die Bewegung des Scheibenwischers sicher vermieden werden, ohne den generell üblichen Scheibenaufbau für Verbundsicherheitsglas grundlegend zu verändern. Dies war für den Fachmann unerwartet und überraschend.

In einer vorteilhaften Weiterbildung der erfindungsgemäßen Scheibenanordnung ist der Anschlussbereich der Sensorelektrode mit einem oder mehreren Flachleitern verbunden und der Flachleiter ist aus der Scheibe herausgeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

In einer vorteilhaften Weiterbildung der erfindungsgemäßen Scheibenanordnung ist die Sensorelektronik mit einer Steuerelektronik verbunden, wobei die Steuerelektronik mit dem elektro-optischen Funktionselement verbunden ist und dessen optische Eigenschaften steuert. Dies erlaubt eine besonders intuitive Bedienung, da der erweiterte kapazitive Schaltbereich deckungsgleich mit dem Bauelement ist, welches geschaltet werden soll.

Als erste Scheibe und zweite Scheibe sind im Grunde alle elektrisch isolierenden Substrate geeignet, die unter den Bedingungen der Herstellung und der Verwendung der erfindungsgemäßen Verbundscheibe thermisch und chemisch stabil sowie dimensions-stabil sind.

Die erste Scheibe und/oder zweite Scheibe enthalten bevorzugt Glas, besonders bevorzugt Flachglas ganz besonders bevorzugt Floatglas, wie Kalk-Natron-Glas Borosilikatglas oder Quarzglas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die erste Scheibe und/oder zweite Scheibe sind bevorzugt transparent, insbesondere für die Verwendung der Scheiben als Windschutzscheibe oder Rückscheiben eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrsrelevanten Sichtfeld des Fahrers liegen, beispielsweise für Dachscheiben, kann die Transmission aber auch viel geringer sein, beispielsweise größer als 5 %.

Die Dicke von erster Scheibe und/oder zweiter Scheibe kann breit variieren und so hervorragend den Erfordernissen des Einzelfalls angepasst werden. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheiben kann breit variieren und richtet sich nach der Größe der erfindungsgemäßen Verwendung. Die erste Scheibe und zweite Scheibe weisen beispielsweise im Fahrzeugbau und Architekturbereich übliche Flächen von 200 cm² bis zu 20 m² auf.

Die Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Scheiben planar oder leicht oder stark in einer Richtung oder in mehreren Richtungen des Raumes gebogen. Insbesondere werden planare Substrate verwendet. Die Scheiben können farblos oder gefärbt sein.

Die erste Scheibe und die zweite Scheibe werden durch mindestens eine Zwischenschicht, bevorzugt durch eine erste und eine zweite Zwischenschicht miteinander verbunden. Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und / oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder auch durch mehrere übereinander angeordnete Folien ausgebildet werden, wobei die Dicke einer Folie bevorzugt von 0,025 mm bis 1 mm beträgt, typischerweise 0,38 mm oder 0,76 mm. Die Zwischenschichten können bevorzugt thermoplastisch sein und nach der Lamination die erste Scheibe, die zweite Scheibe und eventuelle weitere Zwischenschichten miteinander verkleben. In einer besonders vorteilhaften Ausgestaltung der erfindungsgemäßen Verbundscheibe ist die erste Zwischenschicht als Klebeschicht aus einem Klebstoff ausgebildet, mit der die Trägerfolie auf der ersten Scheibe aufgeklebt ist. In diesem Fall hat die erste Zwischenschicht bevorzugt die Abmessungen der Trägerfolie.

Die Begriffe "erste Scheibe" und "zweite Scheibe" sind zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Verbundscheibe beispielsweise dafür vorgesehen, in einer Öffnung, beispielsweise eines Fahrzeugs oder eines Gebäudes, den Innenraum gegenüber der äußeren Umgebung abzutrennen, so kann die erste Scheibe dem Innenraum oder der äußeren Umgebung zugewandt sein.

Die erste und die zweite Flächenelektrode enthalten bevorzugt eine transparente, elektrisch leitfähige Beschichtung. Transparent bedeutet hier durchlässig für elektromagnetische Strahlung, vorzugsweise elektromagnetische Strahlung einer Wellenlänge von 300 nm bis 1.300 nm und insbesondere für sichtbares Licht.

Erfindungsgemäße Flächenelektroden sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und/oder Chrom, oder eine Metalllegierung. Die funktionellen Schichten enthalten besonders bevorzugt mindestens 90 Gew. % des Metalls, insbesondere mindestens 99,9 Gew. % des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Die dielektrische Schicht kann aber auch mehrere Einzelschichten umfassen, beispielsweise Einzelschichten aus einem dielektrischen Material, Glättungsschichten, Anpassungsschichten, Blockerschichten und / oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete Flächenelektroden enthalten bevorzugt Indium-Zinnoxid (ITO), fluordotiertes Zinnoxid (SnO₂:F) oder aluminiumdotiertes Zinkoxid (ZnO:Al).

Die Flächenelektrode kann prinzipiell jede Beschichtung sein, die elektrisch kontaktiert werden kann. Soll die erfindungsgemäße Scheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die Flächenelektrode eine Schicht oder ein Schichtaufbau mehrerer Einzelschichten mit einer Gesamtdicke von kleiner oder gleich 2 µm, besonders bevorzugt kleiner oder gleich 1 µm.

Eine vorteilhafte erfindungsgemäße Flächenelektrode weist einen Flächenwiderstand von 0,4 Ohm/Quadrat bis 400 Ohm/Quadrat auf. In einer besonders bevorzugten Ausgestaltung weist die erfindungsgemäße Flächenelektrode einen Flächenwiderstand von 100 Ohm/Quadrat bis 400 Ohm/Quadrat und insbesondere von 150 Ohm/Quadrat bis 400 Ohm/Quadrat auf.

In einer vorteilhaften Ausgestaltung der Verbundscheibe ist das elektro-optische Funktionselement um eine Breite von 2 mm bis 50 mm, bevorzugt von 5 mm bis 20 mm vom Rand der Verbundscheibe entfernt angeordnet. Das elektro-optische Funktionselement weist dann keinen Kontakt zur Atmosphäre auf und ist im Inneren der Verbundscheibe durch die Zwischenschichten vorteilhaft vor Beschädigungen und Korrosion geschützt.

Die elektrische Zuleitung, die die Flächenelektroden und/oder die Sensorelektrode mit einer äußeren Steuerelektronik beziehungsweise Sensorelektronik verbindet, ist bevorzugt als Folienleiter oder flexibler Folienleiter (Flachleiter, Flachbandleiter) ausgebildet. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können ohne Schwierigkeiten zwischen den einzelnen Scheiben in der thermoplastischen Zwischenschicht eingebettet werden. In einem Folienleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

Die elektrische Leitungsverbindung zwischen dem Anschlussbereiche einer elektrisch leitfähigen Schicht auf einer Trägerfolie und der elektrischen Zuleitung erfolgt bevorzugt über elektrisch leitfähige Kleber, die eine sichere und dauerhaft elektrische Leitungsverbindung zwischen Anschlussbereich und Zuleitung ermöglichten. Alternativ kann die elektrische Leitungsverbindung auch durch Klemmen erfolgen, da die Klemmverbindung durch den Laminiervorgang verrutschungssicher fixiert wird. Alternativ kann die Zuleitung auch auf den Anschlussbereich aufgedruckt werden, beispielsweise mittels einer metallhaltigen und insbesondere silberhaltigen, elektrisch leitfähigen Druckpaste.

Ein weiterer Aspekt der Erfindung umfasst ein Verfahren zur Herstellung einer erfindungsgemäßen Scheibenanordnung mit Verbundscheibe mit kapazitivem Schaltbereich, mindestens umfassend:
(a) Aufbringen einer elektrisch leitfähigen Schicht auf einer Oberfläche einer Trägerfolie,
(b) Einbringen mindestens einer Trennlinie, die die elektrisch leitfähige Schicht in mindestens einen ersten Teilbereich einer Sensorelektrode und mindestens einen Umgebungsbereich elektrisch unterteilt, bevorzugt durch Laserstrukturierung oder durch mechanisches oder chemisches Abtragen, und
(c) Herstellen einer Stapelfolge aus einer ersten Scheibe, einer ersten Zwischenschicht, einer zweiten Zwischenschicht und einer zweiten Scheibe, wobei die Trägerfolie zumindest abschnittsweise zwischen der ersten Scheibe und der ersten Zwischenschicht angeordnet wird und ein elektro-optisches Funktionselement, umfassend eine erste Flächenelektrode, zwischen der ersten Zwischenschicht und der zweiten Zwischenschicht angeordnet wird, und wobei die Sensorelektrode zumindest abschnittsweise im Bereich der orthogonalen Projektion der ersten Flächenelektrode angeordnet wird,
(d) Laminieren der Stapelfolge zu einer Verbundscheibe.

Das Aufbringen der elektrisch leitfähigen Schicht in Verfahrensschritt (a) kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die elektrisch leitfähige Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Trägerfolie kann nach Verfahrensschritt (a) einer Temperaturbehandlung unterzogen werden. Dabei wird die Trägerfolie mit der elektrisch leitfähigen Schicht auf eine Temperatur von mindestens 200°C, bevorzugt mindestens 300°C erwärmt. Die Temperaturbehandlung kann der Erhöhung der Transmission und / oder der Verringerung des Flächenwiderstands der elektrisch leitfähigen Schicht dienen.

Die Entschichtung einzelner Trennlinien in der elektrisch leitfähigen Schicht erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Die erste beziehungsweise die zweite Zwischenschicht kann durch jeweils eine einzelne oder auch durch zwei oder mehrere Folien, die flächenmäßig übereinander angeordnet werden, ausgebildet werden.

Das Verbinden von erster und zweiter Scheibe in Verfahrensschritt (d) erfolgt bevorzugt unter Einwirkung von Hitze, Vakuum und/oder Druck. Es können an sich bekannte Verfahren zur Herstellung einer Verbundscheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermoplastische Zwischenschicht und die zweite Scheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80°C bis 170°C laminiert werden.

Ein weiterer Aspekt der Erfindung umfasst die Verwendung der erfindungsgemäßen Scheibenanordnung mit Verbundscheibe mit erweitertem kapazitivem Schaltbereich in Gebäuden, insbesondere im Zugangsbereich, Fensterbereich, Dachbereich oder Fassaden-bereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seiten-scheibe und / oder Dachscheibe.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer Verbundscheibe,
- Figur 1B: eine Querschnittsdarstellung entlang der Schnittlinie A-A' aus Figur 1A,
- Figur 1C: eine vergrößerte Darstellung der Trägerfolie aus Figur 1A,
- Figur 2: eine Draufsicht auf eine alternative Ausgestaltung einer erfindungsgemäßen Scheibenanordnung mit einer Verbund-scheibe,
- Figur 3A: eine Draufsicht auf eine weitere alternative Ausgestaltung einer erfindungsgemäßen Scheibenanordnung mit einer Verbundscheibe,
- Figur 3B: eine vergrößerte Darstellung des Ausschnitts Z aus Figur 3A,
- Figur 3C: eine Querschnittsdarstellung entlang der Schnittlinie B-B' aus Figur 3B, und
- Figur 4: ein detailliertes Flussdiagramm einer Ausführungsform des erfindungsgemäßen Verfahrens.

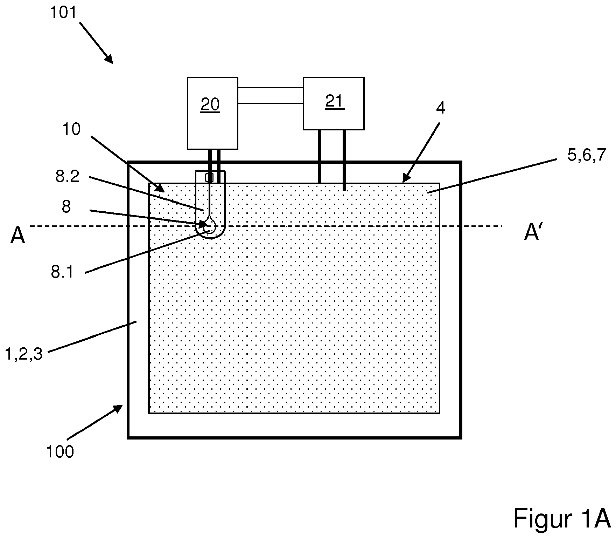

Figur 1A zeigt eine Draufsicht auf eine beispielhafte Ausgestaltung einer erfindungsgemäßen Scheibenanordnung 101 mit einer Verbundscheibe 100 am Beispiel einer Bauverglasung. Die Verbundscheibe 100 kann Teil einer Isolierverglasung sein und beispielsweise als Außenscheibe in einem Fenster eines Gebäudes dienen. Alternativ kann die Verbundscheibe 100 in einem Innenraum angeordnet sein und beispielsweise eine Verglasung eines Besprechungsraums sein.

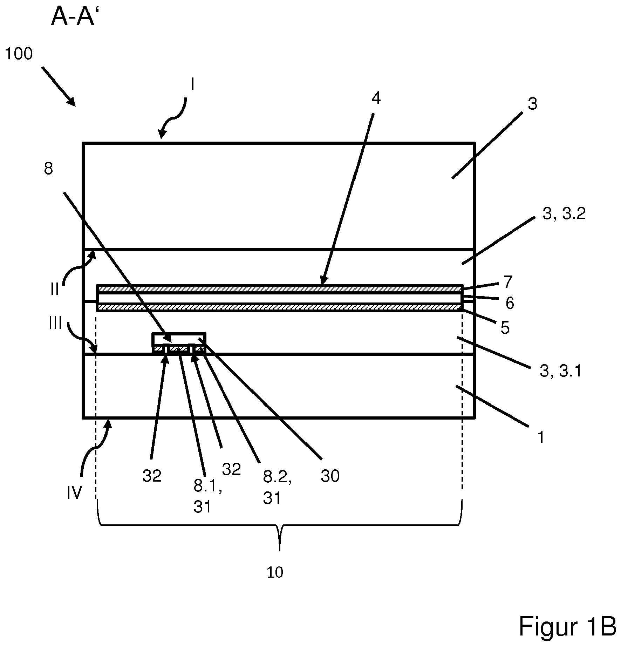

In Figur 1B ist eine Querschnittsdarstellung entlang der Schnittlinie A-A' aus Figur 1A dargestellt. Die Verbundscheibe 100 umfasst hier beispielsweise eine erste Scheibe 1 und eine zweite Scheibe 2, die über eine erste Zwischenschicht 3.1 und eine zweite Zwischenschicht 3.2 miteinander verbunden sind.

Die Abmessungen der Verbundscheibe 100 betragen beispielsweise 1,4 m x 1,5 m. Die erste Scheibe 1 ist beispielsweise dafür vorgesehen, in Einbaulage einem Innenraum zugewandt zu sein. Das heißt, die außenseitige Oberfläche IV der ersten Scheibe 1 ist vom Innenraum aus zugänglich, wogegen die außenseitige Oberfläche I der zweiten Scheibe 2 bezüglich des Innenraums nach außen weist. Die erste Scheibe 1 und die zweite Scheibe 2 bestehen beispielsweise aus Natron-Kalkglas. Die Dicke der ersten Scheibe 1 beträgt beispielsweise 3 mm und die Dicke der zweiten Scheibe 2 beträgt beispielsweise 4 mm. Es versteht sich, dass die erste Scheibe 1 und die zweite Scheibe 2 beliebige Dicken aufweisen können und beispielsweise auch gleich dick ausgebildet sein können. Die Zwischenschichten 3.1,3.2 sind thermoplastische Zwischenschichten und bestehen beispielsweise aus Ethylenvinylacetat (EVA). Sie weisen jeweils eine Dicke von 0,7 mm auf. Im mittleren, linken, oberen Abschnitt der Verbundscheibe 100 ist zwischen der ersten Zwischenschicht 3.1 und der zweiten Zwischenschicht 3.2 eine Trägerfolie 30 mit einer Sensorelektrode 8 angeordnet.

Zwischen der ersten Zwischenschicht 3.1 und der zweiten Zwischenschicht 3.2 ist ein flächenhaftes elektro-optisches Funktionselement 4 angeordnet. Das Funktionselement 4 erstreckt sich beispielsweise vollständig über die Fläche der Verbundscheibe 100 abzüglich eines schmalen Randbereichs, der der elektrischen Isolation des Funktionselements 4 und dem Schutz der Komponenten des Funktionselements 4 vor beispielsweise Feuchtigkeit und Oxidation dient. Der Randbereich ist durch ein Verkleben der ersten Zwischenschicht 3.1 und zweiten Zwischenschicht 3.2 versiegelt.

Das elektro-optische Funktionselement 4 umfasst eine erste Flächenelektrode 5, eine elektro-optische Schicht 6 und eine zweite Flächenelektrode 7, die flächig übereinander angeordnet sind, das heißt, die über ihre Flächen übereinander gestapelt sind. Die erste Flächenelektrode 5 ist dabei zur ersten Zwischenschicht 3.1 unmittelbar benachbart angeordnet und somit der ersten Scheibe 1 zugewandt. Die zweite Flächenelektrode 7 ist dabei zur zweiten Zwischenschicht 3.2 unmittelbar benachbart angeordnet und somit der ersten Scheibe 1 zugewandt. Die elektro-optische Schicht 6 ist beispielweise ein SPD-(Suspended Particle Device)-Schichtsystem, dass durch die erste Flächenelektrode 5 und die zweite Flächenelektrode 7 elektrisch kontaktiert wird.

Hierzu weisen die Flächenelektroden 5,7 einen Flächenwiderstand von 150 Ohm/Quadrat bis 400 Ohm/Quadrat und beispielsweise von 250 Ohm/Quadrat auf.

Die Transparenz der elektro-optische Schicht 6 kann durch ein Spannungssignal, welches an die Flächenelektroden 5,7 angelegt wird, gesteuert werden. Dazu sind die Flächenelektroden 5,7 mit einer Steuerelektronik 21 elektrisch verbunden, beispielsweise über zwei Folienleiter aus jeweils einer 50 µm dicken Kupferfolie.

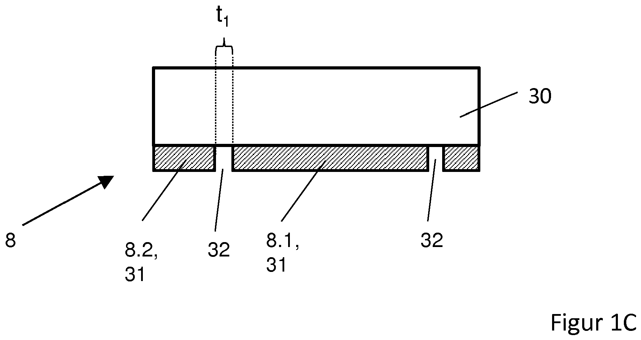

Figur 1C zeigt eine vergrößerte Querschnittsdarstellung der erfindungsgemäßen Trägerfolie 30 aus Figur 1B. Die Trägerfolie 30 ist in diesem Beispiel eine transparente Polyethylenterephthalat (PET)-Folie mit einer Dicke von beispielsweise 0,05 mm. Auf der Trägerfolie 30 ist eine transparente, elektrisch leitfähige Schicht 31 angeordnet. Die elektrische leitfähige Schicht 31 ist ein Schichtensystem, welches beispielsweise drei elektrisch leitfähige Silberschichten enthält, die durch dielektrische Schichten voneinander getrennt sind.

Die elektrisch leitfähige Schicht 31 erstreckt sich beispielsweise über eine gesamte Seite der Trägerfolie 30. Im dargestellten Ausführungsbeispiel ist die elektrisch leitfähige Schicht 31 auf derjenigen Seite der Trägerfolie 5 angeordnet, die der ersten Scheibe 1 zugewandt ist. Die Trägerfolie 5 ist um einen Abstand von etwa 8 mm vom Scheibenrand ins Scheibeninnere versetzt. Dieser Bereich wird durch Verkleben der beiden Zwischenschichten 2,3 während des Laminierens hermetisch versiegelt, so dass die elektrisch leitfähige Schicht 6 vor Feuchtigkeit aus der Umgebung der Verbundscheibe 100 und damit vor Korrosion und Beschädigung geschützt ist. Alternativ wäre es möglich, die Trägerfolie 5 in einem Randbereich beschichtungsfrei zu lassen oder die elektrisch leitfähige Schicht 6 dort zur entfernen.

Die elektrisch leitfähige Schicht 31 ist durch beschichtungsfreie Trennlinien 32 in unterschiedliche, voneinander elektrisch isolierte Bereiche unterteilt: einen ersten Teilbereich 8.1 und einen zweiten Teilbereich, der im Folgenden Umgebungsbereich 8.2 genannt wird.

Die Trennlinie 32 hat lediglich eine Breite t₁ von beispielsweise 100 µm und ist beispielsweise durch Laserstrukturierung in die elektrisch leitfähige Schicht 31 eingebracht. Trennlinien 32 mit einer derart geringen Breite sind optisch kaum wahrnehmbar und stören die Durchsicht durch die Verbundscheibe 100 nur wenig, was besonders ästhetisch ist.

Der erste Teilbereich 8.1 und der Umgebungsbereich 8.2 bilden zusammen eine kapazitive Sensorelektrode 8, wobei die Kapazitätsmessung differenziell zwischen dem ersten Teilbereich 8.1 und dem Umgebungsbereich 8.2 gemessen wird. Der erste Teilbereich 8.1 ist im Wesentlichen kreisförmig ausgebildet und der Umgebungsbereich 8.2 umgibt den Teilbereich 8.1 nahezu vollständig. Der kreisförmige erste Teilbereich 8.1 hat beispielsweise einen Durchmesser von 40 mm. Der Teilbereich 8.1 und der Umgebungsbereich 8.2 werden über die elektrische leitfähige Schicht 31 auf der Trägerfolie 30 in den Randbereich der Verbundscheibe 100 geführt und dort über eine externe Zuleitung mit einer kapazitiven Sensorelektronik 20 verbunden.

Eine sichere elektrisch leitende Verbindung zwischen externer Zuleitung und Sensorelektrode 8 wird dabei beispielsweise durch einen elektrisch leitfähigen Kleber erzielt. Die externe Zuleitung besteht beispielsweise aus einer 50 µm dicken Kupferfolie und ist beispielsweise außerhalb des unmittelbaren Anschlussbereichs mit einer Polyimid-Schicht isoliert. Dadurch kann beispielsweise einer der Folienleiter ohne elektrischen Kurzschluss über den Umgebungsbereich 8.2 hinweg über den unteren Rand der Verbundscheibe 100 hinausgeführt werden. Es versteht sich, dass die elektrische Leitungsverbindung des Anschlussbereichs nach außen auch über isolierte Drähte oder über einen Bereich, in dem die elektrisch leitfähige Schicht des Umgebungsbereichs unterbrochen ist, nach außen geführt werden kann.

Der Teilbereich 8.1 und der Umgebungsbereich 8.2 sind mit einer kapazitiven Sensorelektronik 20 verbunden. Die Sensorelektronik 20 ist dazu geeignet Kapazitätsänderungen der Sensorelektrode 8, das heißt des ersten Teilbereichs 8.1 gegenüber dem Umgebungsbereich 8.2 präzise zu messen und in Abhängigkeit eines Schwellwerts ein Schaltsignal auszugeben. Die Sensorelektronik 20 ist beispielsweise mit der Steuerelektronik 21 des elektro-optischen Funktionselements 4 verbunden. Über das Schaltsignal kann dann beispielsweise die Transparenz des elektro-optischen Funktionselements 4 und damit der Verbundscheibe 100 gesteuert werden.

Die Sensorelektrode 8 und insbesondere der erste Teilbereich 8.1 sind in diesem Beispiel vollständig überlappend zum elektro-optischen Funktionselement 4 angeordnet. Das heißt, die Sensorelektrode 8 ist im Bereich der orthogonalen Projektion bezüglich des elektro-optischen Funktionselements 4 angeordnet.

Durch den geringen Abstand zwischen der elektrisch leitfähigen Schicht 21 der Sensorelektrode 8 und der ersten Flächenelektrode 5 sind Sensorelektrode 8 und erste Flächenelektrode 5 miteinander kapazitiv gekoppelt. Durch den geringen Abstand, der lediglich aus der Schichtdicke der Trägerfolie 30 und der Schichtdicke der ersten Zwischenschicht 3.1 besteht, ist die kapazitive Kopplung derart groß, dass bei einer Berührung der außenseitigen Oberfläche IV der ersten Scheibe 1 eine Kapazitätsänderung über die Sensorelektrode 8 und die Sensorelektronik 20 gemessen werden kann. Dies erfolgt auch, wenn die außenseitige Oberfläche IV der ersten Scheibe 1 nicht unmittelbar über der Sensorelektrode 8 berührt wird, sondern im kompletten Bereich über der ersten Flächenelektrode 5. Dies war für den Fachmann unerwartet und überraschend.

Im dargestellten Ausgestaltungsbeispiel ist die Sensorelektronik 20 derart abgestimmt, dass bei Berührung der außenseitigen Oberfläche IV der ersten Scheibe 1 über der ersten Flächenelektrode 5 und damit über der Fläche des elektro-optischen Funktionselements 4 ein Schaltsignal ausgelöst wird.

Die Sensorelektronik 20 kann derart abgestimmt werden, dass bei Berührung der außenseitigen Oberfläche I der zweiten Scheibe 2 über dem elektro-optischen Funktionselement 4 kein Schaltsignal ausgelöst wird. Die elektro-optische Schicht 6 und die zweite Flächenelektrode 7 schirmen die erste Flächenelektrode 5 ab und erhöhen dadurch die Asymmetrie der Empfindlichkeit.

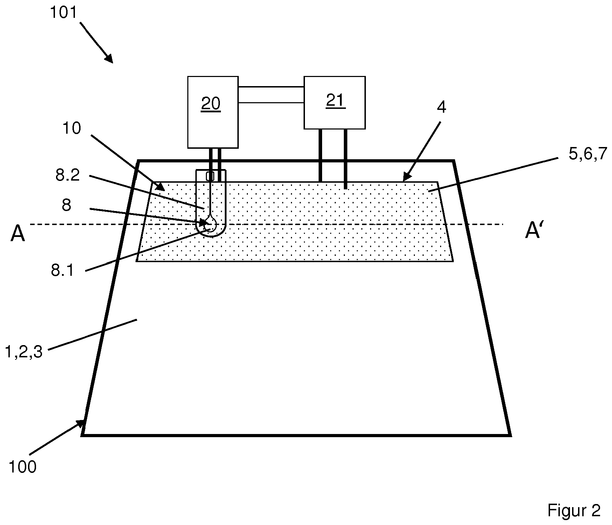

Figur 2 zeigt eine Draufsicht auf eine beispielhafte Ausgestaltung einer alternativen erfindungsgemäßen Scheibenanordnung 101 mit einer Verbundscheibe 100 am Beispiel einer Fahrzeugscheibe und insbesondere die Windschutzscheibe eines Personenkraftwagens. Die Scheibenanordnung 101 und die Verbundscheibe 100 aus Figur 2 entsprechen weitestgehend der Scheibenanordnung 101 und Verbundscheibe 100 aus den Figuren 1A-C, so dass hier nur auf die Unterschiede eingegangen wird.

Die Abmessungen der Verbundscheibe 100 betragen beispielsweise 0,9 m x 1,5 m. Die erste Scheibe 1 ist beispielsweise dafür vorgesehen, in Einbaulage dem Innenraum eines Fahrzeugs zugewandt zu sein. Das heißt, die außenseitige Oberfläche IV der ersten Scheibe 1 ist vom Innenraum aus zugänglich, wogegen die außenseitige Oberfläche I der zweiten Scheibe 2 bezüglich des Fahrzeuginnenraums nach außen weist. Erste Scheibe 1 und zweite Scheibe 2 bestehen beispielsweise aus Natron-Kalkglas. Die Dicke der ersten Scheibe 1 beträgt beispielsweise 1,6 mm und die Dicke der zweiten Scheibe 2 beträgt beispielsweise 2,1 mm. Es versteht sich, dass erste Scheibe 1 und zweite Scheibe 2 beliebige Dicken aufweisen können und beispielsweise auch gleich dick ausgebildet sein können.

Im dargestellten Beispiel ist im oberen Bereich der Verbundscheibe 100 ein flächenhaftes elektro-optisches Funktionselement 4 angeordnet. Das Funktionselement 4 erstreckt sich beispielsweise vollständig über die Breite der Verbundscheibe 100 abzüglich eines schmalen Randbereichs. Das Funktionselement 4 erstreckt sich nur über einen Streifen von beispielsweise 20 cm im oberen Bereich der Verbundscheibe 100 und dient dort als Sonnenblende. Das elektro-optische Funktionselement 4 ist beispielsweise ein SPD-Funktionselement, wie es in Figur 1A-C beschrieben ist und enthält eine erste Flächenelektrode 5, eine elektro-optische Schicht 6 aus beispielweise einem SPD-(Suspended Particle Device)-Schichtsystem und einer zweiten Flächenelektrode 7.

Das elektro-optische Funktionselement 4 ist, wie in Figur 1B dargestellt, zwischen einer ersten Zwischenschicht 3.1 und einer zweiten Zwischenschicht 3.2 angeordnet. Im Unterschied zu den Zwischenschichten 3.1,3.2 aus Figur 1B bestehen die Zwischenschichten 3.1,3.2 in diesem Beispiel aus Polyvinylbutyral (PVB) und weisen jeweils eine Dicke von 0,38 mm auf.

Im oberen linken Bereich der Verbundscheibe 100 ist eine Sensorelektrode 8 angeordnet. Die Sensorelektrode 8 entspricht beispielsweise der Sensorelektrode 8, wie sie in den Figuren 1A-1C dargestellt ist. Auch hier sind der erste Teilbereich 8.1 und der Umgebungsbereich 8.2 aus einer mit Trennlinien 32 unterteilten transparenten, elektrisch leitfähigen Schicht 31 gebildet, die auf einer Trägerfolie 32 angeordnet sind. Auch in diesem Beispiel ist die kapazitive Sensorelektronik 20 mit der Steuerelektronik 21 des elektro-optischen Funktionselements 4 verbunden. Ebenso ist die Sensorelektrode 8 mit der ersten Flächenelektrode 5 kapazitiv gekoppelt, so dass sich der kapazitive Schaltbereich 10, in dem ein Schaltsignal bei Berührung oder Annäherung an die außenseitige Oberfläche IV der ersten Scheibe 1 ausgelöst werden kann, auf den Bereich über der ersten Flächenelektrode 5 erweitert. Das heißt, zur Auslösung eines Schaltsignals muss nicht der Bereich unmittelbar über der Sensorelektrode 8 berührt werden, sondern es genügt eine Berührung des Bereichs über der ersten Flächenelektrode 5. Dies erlaubt eine besonders intuitive Bedienung der Abschattungsfunktion der Sonnenblende, da nicht eine bestimmte Stelle wie ein Schalter oder eine kleine Schaltfläche berührt werden müssen, sondern es genügt einen beliebigen Bereich der Verbundscheibe 100 über der Sonnenblende zu berühren um eine Änderung der Transparenz herbeizuführen. Eine gesonderte Markierung eines Schaltbereichs auf der Verbundscheibe kann vermieden werden, was technisch einfach, kostengünstiger und ästhetisch ansprechender ist.

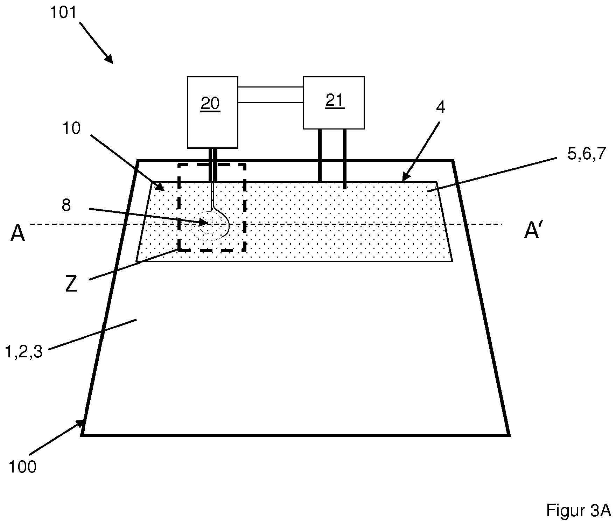

Figur 3A zeigt eine Draufsicht auf eine weitere alternative beispielhafte Ausgestaltung einer erfindungsgemäßen Scheibenanordnung 101 mit einer Verbundscheibe 100. Die Scheibenanordnung 101 und die Verbundscheibe 100 entsprechen weitestgehend der Scheibenanordnung 101 und Verbundscheibe 100 aus Figur 2, so dass hier nur auf die Unterschiede eingegangen wird.

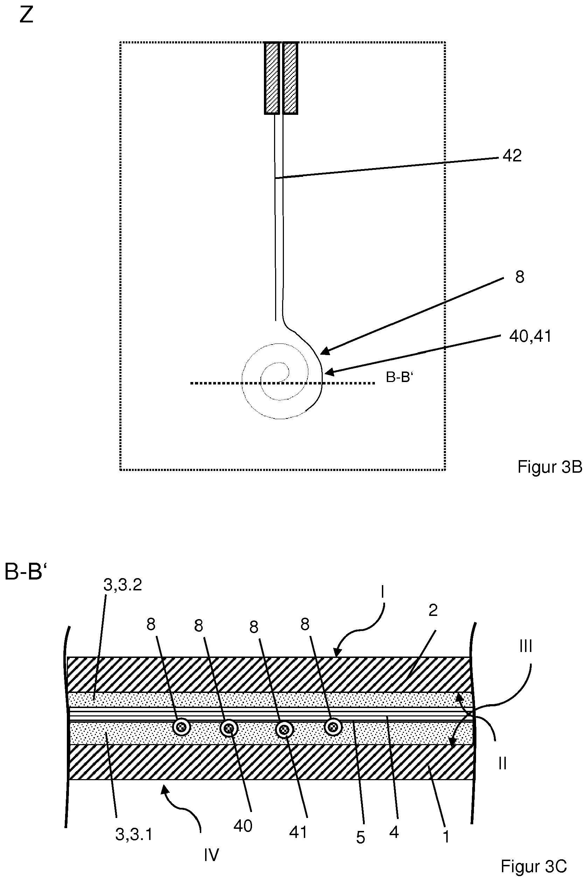

Im Unterschied zu Figur 1A-C und Figur 2 ist die Sensorelektrode 8 hier aus einem Metalldraht 40 und beispielsweise aus Kupferdraht mit einer Dicke von beispielsweise 200 µm ausgestaltet. Der Metalldraht 40 ist durch eine Kunststoffschicht isoliert (Isolation 40). Wie Figur 3C zeigt, kann der Metalldraht 40 unmittelbar benachbart zur ersten Flächenelektrode 5 angeordnet sein, da durch die Insolation 41 eine galvanische Verbindung unterbunden und eine kapazitive Kopplung sichergestellt wird.

Figur 3B zeigt eine vergrößerte Darstellung des Bereichs Z aus Figur 3A. Der Metalldraht ist beispielsweise spiralförmig angeordnet, was die effektive kapazitive Fläche der Sensorelektrode 8 vergrößert. Optional ist hier ein Massedraht 42 dargestellt, der eine differenzielle Kapazitätsmessung erlaubt. Es sei besonders betont, dass auch ein Metalldraht 40 ohne Massedraht 42 den erfindungsgemäßen Effekt zeigt, nämlich die Erweiterung des kapazitiven Schaltbereichs der Sensorelektrode 8 auf den gesamten Bereich über der ersten Flächenelektrode 5 und damit über den gesamten Bereich des elektro-optischen Funktionselements 4.

In einem weiteren, hier nicht dargestellten Beispiel ist die Verbundscheibe als Dachscheibe in einem Kraftfahrzeug ausgebildet. Dabei die erstreckt sich das elektro-optische Funktionselement über die gesamte Dachscheibe, abzüglich eines Randbereichs, der der elektrischen Isolation und dem Schutz vor Korrosion dient.

Durch die erfindungsgemäße Erweiterung des kapazitiven Schaltbereich kann jeder Fahrzeuginsasse durch Berührung der außenseitigen Oberfläche IV der ersten Scheibe (also der dem Innenraum zugewandten Scheibe) ein Schaltereignis ausführen und beispielsweise die Transparenz des elektro-optischen Funktionselements steuern. Dies ist technisch besonders einfach und für alle Fahrzeuginsassen sehr komfortabel. Enthält das elektro-optische Funktionselement beispielsweise eine OLED-Schicht als elektro-optische Funktionsschicht so kann bei geeigneter Beschaltung jeder Fahrzeuginsasse eine Beleuchtung des Innenraums herbeiführen.

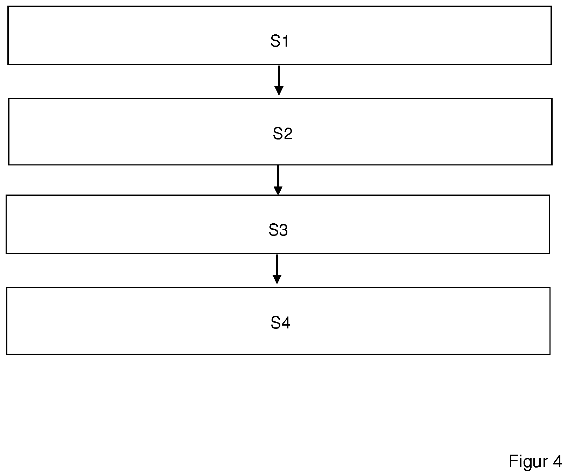

Figur 4 zeigt ein Flussdiagramm eines Ausführungsbeispiels des erfindungsgemäßen Verfahrens zur Herstellung einer Verbundscheibe 100 mit erweitertem kapazitivem Schaltbereich 10 umfassend die folgenden Verfahrensschritte S1-S4.
S1: Aufbringen einer elektrisch leitfähigen Schicht 31 auf einer Oberfläche einer Trägerfolie 30;
S2: Einbringen mindestens einer Trennlinie 32, die die Schicht 31 in mindestens einen ersten Teilbereich 8.1 einer Sensorelektrode 8 und mindestens einen Umgebungsbereich 8.2 elektrisch unterteilt, bevorzugt durch Laserstrukturierung oder durch mechanisches oder chemisches Abtragen;
S3: Herstellen einer Stapelfolge aus einer ersten Scheibe 1, einer ersten Zwischenschicht 3.1, einer zweiten Zwischenschicht 3.2 und einer zweiten Scheibe 2, wobei die Trägerfolie 30 zumindest abschnittsweise zwischen der ersten Scheibe 1 und der ersten Zwischenschicht 3.1 angeordnet wird und ein elektro-optisches Funktionselement 4 mindestens umfassend eine erste Flächenelektrode 5, zwischen der ersten Zwischenschicht 3.1 und der zweiten Zwischenschicht 3.2 angeordnet wird, wobei die Sensorelektrode 8 zumindest abschnittsweise im Bereich der orthogonalen Projektion der ersten Flächenelektrode 5 angeordnet wird; und
S4: Laminieren der Stapelfolge zu einer Verbundscheibe 100.

### Bezugszeichenliste

- 1: erste Scheibe
- 2: zweite Scheibe
- 3: Zwischenschicht
- 3.1: erste Zwischenschicht
- 3.2: zweite Zwischenschicht
- 4: elektro-optisches Funktionselement
- 5: erste Flächenelektrode
- 6: elektro-optische Schicht
- 7: zweite Flächenelektrode
- 8: Sensorelektrode
- 8.1: erster Teilbereich der Sensorelektrode 8
- 8.2: Umgebungsbereich
- 10: erweiterter kapazitiver Schaltbereich
- 20: kapazitive Sensorelektronik
- 21: Steuerelektronik für das elektro-optische Funktionselement 4
- 30: Trägerfolie
- 31: elektrisch leitfähige Schicht
- 32: Trennlinie
- 40: Metalldraht
- 41: Isolation des Metalldrahts 40
- 42: Massedraht
- 100: Verbundscheibe
- 101: Scheibenanordnung
- A-A': Schnittlinie
- B-B': Schnittlinie
- S1,S2,S3,S4: Verfahrensschritte
- I: außenseitige Oberfläche der zweiten Scheibe 2
- II: innenseitige Oberfläche der zweiten Scheibe 2
- IV: innenseitigen Oberfläche des ersten Scheibe 1
- IV: außenseitigen Oberfläche des ersten Scheibe 1

## Patentansprüche

1. Scheibenanordnung (101) umfassend:
- eine erste Scheibe (1) und eine zweite Scheibe (2), die durch mindestens eine Zwischenschicht (3) miteinander verbunden sind,
- ein elektro-optisches Funktionselement (4), umfassend eine erste Flächenelektrode (5), eine elektro-optische Funktionsschicht (6) und eine zweite Flächenelektrode (7), wobei das Funktionselement (4) zwischen der ersten Scheibe (1) und der zweiten Scheibe (2) angeordnet ist und die erste Flächenelektrode (5) der ersten Scheibe (1) zugewandt ist und die zweite Flächenelektrode (7) der zweiten Scheibe (7) zugewandt ist,
- eine Sensorelektrode (8), die zwischen der ersten Flächenelektrode (5) und der ersten Scheibe (1) angeordnet ist und die Sensorelektrode (8) kapazitiv mit der ersten Flächenelektrode (5) gekoppelt ist,
- eine kapazitive Sensorelektronik (20), die mit der Sensorelektrode (8) elektrisch verbunden ist, wobei die Empfindlichkeit der Sensorelektronik (20) so gewählt ist, dass ein kapazitiver Schaltbereich auf die Fläche einer orthogonalen Projektion der ersten Flächenelektrode auf die außenseitige Oberfläche (IV) der ersten Scheibe ausgedehnt wird, so dass sie bei Berührung der außenseitigen Oberfläche (IV) der ersten Scheibe (1) über der ersten Flächenelektrode (5) oder der Annäherung an die außenseitige Oberfläche (IV) der ersten Scheibe (1) über der ersten Flächenelektrode (5) mit einem menschlichen Körperteil, wie einem Finger oder einer Hand, ein Schaltsignal ausgibt.

2. Scheibenanordnung (101) nach Anspruch 1, wobei das elektro-optische Funktionselement (4) ein flächenhaftes Funktionselement ist, dessen optische Eigenschaften und insbesondere dessen Transparenz, Streuverhalten oder Leuchtkraft durch ein elektrisches Spannungssignal steuerbar ist, wobei die elektro-optische Funktionsschicht (6) bevorzugt eine SPD-Folie (SPD ₌ Suspended particle device) oder eine Flüssigkristall-haltige Folie, wie eine PDLC-Folie (PDLC ₌ Polymer dispersed liquid crystal), ein elektrochromes Schichtsystem oder ein OLED-Schichtsystem (OLED, englisch organic light emitting diode; organische Leuchtdiode), eine Display-Folie, bevorzugt eine OLED-Display-Folie, besonders bevorzugt eine transparente OLED-Display-Folie, ist.

3. Scheibenanordnung (101) nach Anspruch 1 oder 2, wobei die Sensorelektrode (8)
- eine gedruckte und eingebrannte elektrisch leitfähigen Paste, bevorzugt eine silberhaltige Siebdruckpaste und/oder
- eine elektrisch leitfähigen Folie, bevorzugt eine Metallfolie und insbesondere einer Kupfer-, Silber-, Gold- oder Aluminiumfolie und/oder
- einen elektrisch leitfähigen Draht, bevorzugt einen Metalldraht (40), bevorzugt einen Wolfram-, Kupfer-, Silber-, Gold- oder Aluminiumdraht und besonders bevorzugt einen Metalldraht (40) mit elektrischer Isolierung (41) und/oder
- eine elektrisch leitfähige Schicht (31), die bevorzugt unmittelbar auf der innenseitigen Oberfläche (III) der ersten Scheibe (1) oder auf einer Trägerfolie (30) angeordnet ist,
enthält oder daraus besteht.

4. Scheibenanordnung (101) nach Anspruch 3, wobei die Sensorelektrode (8) aus einer elektrisch leitfähigen Schicht (30) besteht und ein elektrisch leitfähiger erster Teilbereich (8.1) durch einen beschichtungsfreien Trennbereich, insbesondere eine beschichtungsfreie Trennlinie (31), von einem elektrisch leitfähigen Umgebungsbereich (8.2) elektrisch isoliert ist und der erste Teilbereich (8.1) sowie der Umgebungsbereich (8.2) mit einer Sensorelektronik (20) elektrisch verbindbar sind.

5. Scheibenanordnung (101) nach Anspruch 4, wobei der Trennbereich eine Trennlinie ist, wobei eine Breite t₁ der Trennlinie (32) von 30 µm bis 200 µm und bevorzugt von 70 µm bis 140 µm beträgt.

6. Scheibenanordnung (101) nach einem der Ansprüche 4 oder 5, wobei die Fläche der orthogonalen Projektion der Sensorelektrode (8) und insbesondere des ersten Teilbereichs (8.1) der Sensorelektrode (8) auf die erste Flächenelektrode (5) von 1 cm² bis 200 cm², besonders bevorzugt von 1 cm² bis 9 cm² beträgt.

7. Scheibenanordnung (101) nach einem der Ansprüche 1 bis 6, wobei die Sensorelektrode (8) und insbesondere der erste Teilbereich (8.1) der Sensorelektrode (8) eine rechteckförmige, quadratische, trapezförmige, dreiecksförmige, kreisförmige, elliptische oder tropfenförmige Form oder abgerundete Ecken aufweist.

8. Scheibenanordnung (101) nach einem der Ansprüche 3 bis 7, wobei die Sensorelektrode (8) eine elektrisch leitfähige Schicht (31), die auf einer Trägerfolie (30) angeordnet ist, enthält oder daraus besteht, wobei die Trägerfolie (30) transparent ist und bevorzugt Polyethylenterephthalat (PET) oder Polyimid enthält oder daraus besteht.

9. Scheibenanordnung (101) nach einem der Ansprüche 1 bis 8, wobei die erste Scheibe (1) und/oder die zweite Scheibe (2) Glas, bevorzugt Flachglas, besonders bevorzugt Kalk-Natron-Glas, Borosilikatglas oder Quarzglas, oder Polymere, bevorzugt Polyethylen, Polypropylen, Polycarbonat, Polymethylmethacrylat und/oder Gemische davon enthält oder daraus besteht.

10. Scheibenanordnung (101) nach einem der Ansprüche 3 bis 9, wobei die Sensorelektrode (8) eine elektrisch leitfähige Schicht (31) enthält oder daraus besteht, wobei die elektrisch leitfähige Schicht (31)
- transparent ist und/oder
- einen Flächenwiderstand von 0,4 Ohm/Quadrat bis 400 Ohm/Quadrat aufweist und/oder
- Silber (Ag), Indium-Zinnoxid (ITO), fluordotiertes Zinnoxid (SnO₂:F) oder aluminiumdotiertes Zinkoxid (ZnO:Al)
enthält oder daraus besteht,
und/oder die erste Flächenelektrode (5)
- transparent ist und/oder
- einen Flächenwiderstand von 0,4 Ohm/Quadrat bis 400 Ohm/Quadrat aufweist und/oder
- Silber (Ag), Indium-Zinnoxid (ITO), fluordotiertes Zinnoxid (SnO₂:F) oder aluminiumdotiertes Zinkoxid (ZnO:Al)
enthält oder daraus besteht.

11. Scheibenanordnung (101) nach einem der Ansprüche 1 bis 10, wobei die Sensorelektrode (8) in einem Bereich der orthogonalen Projektion der ersten Flächenelektrode (5) angeordnet ist.

12. Scheibenanordnung (101) nach einem der Ansprüche 1 bis 11, wobei die Empfindlichkeit der Sensorelektronik (20) so gewählt ist, dass das Schaltsignal bei einer Berührung oder Annäherung an die außenseitige Oberfläche (I) der zweiten Scheibe (2) über der ersten Flächenelektrode (5) kein Schaltsignal oder ein anderes Schaltsignal ausgibt.

13. Verfahren zur Herstellung einer Scheibenanordnung (101) nach einem der Ansprüche 1 bis 12, mindestens umfassend:
(a) Aufbringen einer elektrisch leitfähigen Schicht (31) auf einer Oberfläche einer Trägerfolie (30),
(b) Einbringen mindestens einer Trennlinie (32), die die elektrisch leitfähige Schicht (31) in mindestens einen ersten Teilbereich (8.1) einer Sensorelektrode (8) und mindestens einen Umgebungsbereich (8.2) elektrisch unterteilt, bevorzugt durch Laserstrukturierung oder durch mechanisches oder chemisches Abtragen,
(c) Herstellen einer Stapelfolge aus einer ersten Scheibe (1), einer ersten Zwischenschicht (3.1), einer zweiten Zwischenschicht (3.2) und einer zweiten Scheibe (2), wobei
- die Trägerfolie (30) zumindest abschnittsweise zwischen der ersten Scheibe (1) und der ersten Zwischenschicht (3.1) angeordnet wird,
- ein elektro-optisches Funktionselement (4) mindestens umfassend eine erste Flächenelektrode (5), zwischen der ersten Zwischenschicht (3.1) und der zweiten Zwischenschicht (3.2) angeordnet wird, und
- die Sensorelektrode (8) zumindest abschnittsweise im Bereich der orthogonalen Projektion der ersten Flächenelektrode (5) angeordnet wird, und
(d) Laminieren der Stapelfolge.

14. Verwendung der Scheibenanordnung (101) nach einen der Ansprüche 1 bis 12 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper, oder als Gebäudeverglasung im Baubereich oder Architekturbereich im Innenbereich oder Außenbereich.

## Claims

1. Pane arrangement (101) comprising:
- a first pane (1) and a second pane (2) that are joined to one another by at least one intermediate layer (3),
- an electro-optical functional element (4), comprising a first surface electrode (5), an electro-optical functional layer (6), and a second surface electrode (7), wherein the functional element (4) is arranged between the first pane (1) and the second pane (2), and the first surface electrode (5) faces the first pane (1), and the second surface electrode (7) faces the second pane (2),
- a sensor electrode (8) that is arranged between the first surface electrode (5) and the first pane (1) and the sensor electrode (8) is capacitively coupled to the first surface electrode (5),
- a capacitive electronic sensor system (20) is electrically connected to the sensor electrode (8), wherein the sensitivity of the electronic sensor system (20) is selected such that a capacitive switching region is expanded to the area of an orthogonal projection of the first surface electrode on the outer surface (IV) of the first pane, so that, when the outer surface (IV) of the first pane (1) is touched above the first surface electrode (5) by a human body part, such as a finger or a hand, or said human body part approaches the outer surface (IV) of the first pane (1) above the first surface electrode (5), a switching signal is emitted.

2. Pane arrangement (101) according to claim 1, wherein the electro-optical functional element (4) is a planar functional element, whose optical properties and in particular whose transparency, scattering behavior, or luminosity can be controlled by an electrical voltage signal, wherein the electro-optical functional layer (6) is preferably an SPD film (SPD ₌ suspended particle device) or a liquid-crystal-containing film, such as a PDLC film (PDLC ₌ polymer dispersed liquid crystal), an electrochromic layer system, or an OLED layer system (organic light emitting diode), a display film, preferably an OLED display film, particularly preferably a transparent OLED display film.

3. Pane arrangement (101) according to claim 1 or 2, wherein the sensor electrode (8) includes or is made of
- a printed and fired electrically conductive paste, preferably a silver-containing screen printing paste and/or
- an electrically conductive foil, preferably a metal foil and in particular a copper, silver, gold, or aluminum foil and/or
- an electrically conductive wire, preferably a metal wire (40), preferably a tungsten, copper, silver, gold, or aluminum wire, and particularly preferably a metal wire (40) with electrical insulation (41) and/or
- an electrically conductive layer (31) that is preferably arranged directly on the inner surface (III) of the first pane (1) or on a carrier film (30).

4. Pane arrangement (101) according to claim 3, wherein the sensor electrode (8) consists of an electrically conductive layer (30) and an electrically conductive first subregion (8.1) is electrically isolated by a coating-free subregion, in particular a coating-free separating line (32), from an electrically conductive surrounding region (8.2), and the first subregion (8.1) and the surrounding region (8.2) can be electrically connected to an electronic sensor system (20).

5. Pane arrangement (101) according to claim 4, wherein the subregion is a separating line, wherein a width t₁ of the separating line (32) is from 30 µm to 200 µm and preferably from 70 µm to 140 µm.

6. Pane arrangement (101) according to one of claims 4 or 5, wherein the area of the orthogonal projection of the sensor electrode (8) and in particular of the first subregion (8.1) of the sensor electrode (8) on the first surface electrode (5) is from 1 cm² to 200 cm², particularly preferably from 1 cm² to 9 cm².

7. Pane arrangement (101) according to one of claims 1 through 6, wherein the sensor electrode (8) and in particular the first subregion (8.1) of the sensor electrode (8) has a rectangular, square, trapezoidal, triangular, circular, elliptical, or drop-shaped shape or rounded corners.

8. Pane arrangement (101) according to one of claims 3 through 7, wherein
the sensor electrode (8) contains or is made of an electrically conductive layer (31) that is arranged on a carrier film (30), wherein the carrier film (30) is transparent and preferably contains or is made of polyethylene terephthalate (PET) or polyimide.

9. Pane arrangement (101) according to one of claims 1 through 8, wherein the first pane (1) and/or the second pane (2) contains or is made of glass, preferably flat glass, particularly preferably soda lime glass, borosilicate glass, or quartz glass, or polymers, preferably polyethylene, polypropylene, polycarbonate, polymethyl methacrylate, and/or mixtures thereof.

10. Pane arrangement (101) according to one of claims 3 through 9, wherein the sensor electrode (8) contains or is made of an electrically conductive layer (31), wherein
the electrically conductive layer (31)
- is transparent and/or
- has a sheet resistance of 0.4 ohm/square to 400 ohm/square and/or
- contains or is made of silver (Ag), indium tin oxide (ITO), fluorine-doped tin oxide (SnO₂:F), or aluminum-doped zinc oxide (ZnO:AI),
and/or
the first surface electrode (5)
- is transparent and/or
- has a sheet resistance of 0.4 ohm/square to 400 ohm/square and/or
- contains or is made of silver (Ag), indium tin oxide (ITO), fluorine-doped tin oxide (SnO₂:F), or aluminum-doped zinc oxide (ZnO:AI).

11. Pane arrangement (101) according to one of claims 1 through 10, wherein the sensor electrode (8) is arranged in a region of the orthogonal projection of the first surface electrode (5).

12. Pane arrangement (101) according to one of claims 1 through 11, wherein the sensitivity of the electronic sensor system (20) is selected such that the switching signal, with touching or approaching of the outer surface (I) of the second pane (2) above the first surface electrode (5), emits no switching signal or a different switching signal.

13. Method for producing a pane arrangement (101) according to one of claims 1 through 12, at least comprising:
(a) applying an electrically conductive layer (31) on a surface of a carrier film (30),
(b) introducing at least one separating line (32), which electrically divides the electrically conductive layer (31) into at least one first subregion (8.1) of a sensor electrode (8) and at least one surrounding region (8.2), preferably by laser patterning or by mechanical or chemical removal,
(c) producing a stack sequence comprising a first pane (1), a first intermediate layer (3.1), a second intermediate layer (3.2), and a second pane (2), wherein
- the carrier film (30) is arranged, at least in sections, between the first pane (1) and the first intermediate layer (3.1),
- an electro-optical functional element (4) at least comprising a first surface electrode (5) is arranged between the first intermediate layer (3.1) and the second intermediate layer (3.2), and
- the sensor electrode (8) is arranged at least in sections in the region of the orthogonal projection of the first surface electrode (5), and
(d) Laminating the stack sequence.

14. Use of the pane arrangement (101) according to one of claims 1 through 12 in means of transportation for travel on land, in the air, or on water, in particular in motor vehicles for example, as a windshield, rear window, side windows, and/or roof panel as well as a functional individual piece, and as a built-in component in furniture, appliances, and buildings, in particular as an electric heater, or as building glazing in the construction sector or the architectural sector indoors or outdoors.

## Revendications

1. Agencement de vitres (101) comprenant :
- une première vitre (1) et une deuxième vitre (2) reliées entre elles par au moins une couche intermédiaire (3),
- un élément fonctionnel électro-optique (4), comprenant une première électrode de surface (5), une couche fonctionnelle électro-optique (6) et une deuxième électrode de surface (7), dans lequel l'élément fonctionnel (4) est disposé entre la première vitre (1) et la deuxième vitre (2), et la première électrode de surface (5) fait face à la première vitre (1), et la deuxième électrode de surface (7) fait face à la deuxième vitre (2),
- une électrode de capteur (8) disposée entre la première électrode de surface (5) et la première vitre (1), l'électrode de capteur (8) étant couplée capacitivement à la première électrode de surface (5),
- un système de capteur électronique capacitif (20) est connecté électriquement à l'électrode de capteur (8), dans lequel la sensibilité du système de capteur électronique (20) est sélectionnée de manière à ce qu'une zone de commutation capacitive soit étendue à la zone d'une projection orthogonale de la première électrode de surface sur la surface extérieure (IV) de la première vitre, de sorte que, lorsque la surface extérieure (IV) de la première vitre (1) est touchée au-dessus de la première électrode de surface (5) par une partie du corps humain, telle qu'un doigt ou une main, ou que ladite partie du corps humain s'approche de la surface extérieure (IV) de la première vitre (1) au-dessus de la première électrode de surface (5), un signal de commutation est émis.

2. Agencement de vitres (101) selon la revendication 1, dans lequel l'élément fonctionnel électro-optique (4) est un élément fonctionnel planaire, dont les propriétés optiques et en particulier la transparence, le comportement de diffusion ou la luminosité peuvent être contrôlées par un signal de tension électrique, dans lequel la couche fonctionnelle électro-optique (6) est de préférence un film SPD (SPD ₌ dispositif à particules en suspension) ou un film contenant des cristaux liquides, tel qu'un film PDLC (PDLC ₌ cristaux liquides dispersés dans des polymères), un système de couches électrochromes ou un système de couches OLED (diode électroluminescente organique), un film d'affichage, de préférence un film d'affichage OLED, de préférence en particulier un film d'affichage OLED transparent.

3. Agencement de vitres (101) selon la revendication 1 ou 2, dans lequel l'électrode de capteur (8) comprend ou est constituée de
- une pâte électriquement conductrice imprimée et cuite, de préférence une pâte sérigraphique contenant de l'argent et/ou
- d'une feuille conductrice d'électricité, de préférence une feuille métallique et en particulier une feuille de cuivre, d'argent, d'or ou d'aluminium et/ou
- un fil électriquement conducteur, de préférence un fil métallique (40), de préférence un fil de tungstène, de cuivre, d'argent, d'or ou d'aluminium, et de préférence un fil métallique (40) avec une isolation électrique (41) et/ou
- une couche électriquement conductrice (31) qui est de préférence disposée directement sur la surface intérieure (III) de la première vitre (1) ou sur un film support (30).

4. Agencement de vitres (101) selon la revendication 3, dans lequel l'électrode de capteur (8) consiste en une couche électriquement conductrice (30) et une première sous-région électriquement conductrice (8.1) est électriquement isolée par une sous-région sans revêtement, en particulier une ligne de séparation sans revêtement (32), d'une région environnante électriquement conductrice (8.2), et la première sous-région (8.1) et la région environnante (8.2) peuvent être électriquement connectées à un système de capteur électronique (20).

5. Agencement de vitres (101) selon la revendication 4, dans lequel la sous-région est une ligne de séparation, dans lequel une largeur t₁ de la ligne de séparation (32) est de 30 µm à 200 µm et de préférence de 70 µm à 140 µm.

6. Agencement de vitres (101) selon l'une des revendications 4 ou 5, dans lequel la surface de la projection orthogonale de l'électrode de détection (8) et en particulier de la première sous-région (8.1) de l'électrode de détection (8) sur la première électrode de surface (5) est comprise entre 1 cm² et 200 cm², de préférence entre 1 cm² et 9 cm².

7. Agencement de vitres (101) selon l'une des revendications 1 à 6, dans lequel l'électrode de capteur (8) et en particulier la première sous-région (8.1) de l'électrode de capteur (8) a une forme rectangulaire, carrée, trapézoïdale, triangulaire, circulaire, elliptique ou en forme de goutte d'eau ou des coins arrondis.

8. Agencement de vitres (101) selon l'une des revendications 3 à 7, dans lequel l'électrode de capteur (8) contient ou est constituée d'une couche électriquement conductrice (31) disposée sur un film support (30), dans lequel le film support (30) est transparent et contient ou est constitué de préférence de polyéthylène téréphtalate (PET) ou de polyimide.

9. Agencement de vitres (101) selon l'une des revendications 1 à 8, dans lequel la première vitre (1) et/ou la deuxième vitre (2) contient ou est faite de verre, de préférence de verre plat, en particulier de verre sodocalcique, de verre borosilicaté ou de verre de quartz, ou de polymères, de préférence de polyéthylène, de polypropylène, de polycarbonate, de polyméthacrylate de méthyle, et/ou de mélanges de ces derniers.

10. Agencement de vitres (101) selon l'une des revendications 3 à 9, dans lequel l'électrode de capteur (8) contient ou est constituée d'une couche électriquement conductrice (31), dans laquelle
la couche conductrice d'électricité (31)
- est transparente et/ou
- a une résistance de feuille de 0,4 ohm/carré à 400 ohm/carré et/ou
- contient ou est constituée d'argent (Ag), d'oxyde d'indium et d'étain (ITO), d'oxyde d'étain dopé au fluor (SnO₂:F) ou d'oxyde de zinc dopé à l'aluminium (ZnO:AI), et/ou
la première électrode de surface (5)
- est transparente et/ou
- a une résistance de feuille de 0,4 ohm/carré à 400 ohm/carré et/ou
- contient de l'argent (Ag), de l'oxyde d'indium et d'étain (ITO), de l'oxyde d'étain dopé au fluor (SnO₂:F) ou de l'oxyde de zinc dopé à l'aluminium (ZnO:AI), ou est fabriquée en ces matières.

11. Agencement de vitres (101) selon l'une des revendications 1 à 10, dans lequel l'électrode de capteur (8) est disposée dans une région de la projection orthogonale de la première électrode de surface (5).

12. Agencement de vitres (101) selon l'une des revendications 1 à 11, dans lequel la sensibilité du système de capteur électronique (20) est sélectionnée de manière à ce que le signal de commutation, lors du contact ou de l'approche de la surface extérieure (I) de la deuxième vitre (2) au-dessus de la première électrode de surface (5), n'émette aucun signal de commutation ou un signal de commutation différent.

13. Procédé de fabrication d'un agencement de vitres (101) selon l'une des revendications 1 à 12, comprenant au moins :
(a) appliquer d'une couche électriquement conductrice (31) sur une surface d'un film support (30),
(b) introduire au moins une ligne de séparation (32) qui divise électriquement la couche conductrice (31) en au moins une première sous-région (8.1) d'une électrode de capteur (8) et au moins une région environnante (8.2), de préférence par modelage au laser ou par enlèvement mécanique ou chimique,
(c) produire une séquence d'empilage comprenant une première vitre (1), une première couche intermédiaire (3.1), une deuxième couche intermédiaire (3.2) et une deuxième vitre (2), dans laquelle
- le film support (30) est disposé, au moins en partie, entre la première vitre (1) et la première couche intermédiaire (3.1),
- un élément fonctionnel électro-optique (4) comprenant au moins une première électrode de surface (5) est disposé entre la première couche intermédiaire (3.1) et la seconde couche intermédiaire (3.2), et
- l'électrode de capteur (8) est disposée, au moins en partie, dans la région de la projection orthogonale de la première électrode de surface (5), et
(d) laminer de la séquence d'empilage.

14. Utilisation de l'agencement de vitres (101) selon l'une des revendications 1 à 12 dans les moyens de transport pour les déplacements sur terre, dans l'air ou sur l'eau, en particulier dans les véhicules à moteur, par exemple, comme pare-brise, lunette arrière, vitres latérales et/ou panneau de toit ainsi que comme pièce individuelle fonctionnelle, et comme composant intégré dans les meubles, les appareils et les bâtiments, en particulier comme chauffage électrique, ou comme vitrage de bâtiment dans le secteur de la construction ou dans le secteur architectural à l'intérieur ou à l'extérieur.
